# FASCICULE DE BREVET EUROPEEN

(11) **EP 1 821 111 B1**
(45) Date de publication et mention de la délivrance du brevet: **22.12.2010**
(21) Numéro de dépôt: 07101953.3
(22) Date de dépôt: 08.02.2007
(51) Int. Cl.: G01R 31/317, G01R 31/3185

(54) **Circuit électronique comprenant un mode de test sécurisé par l'utilisation d'un identifiant, et procédé associé.**
Elektronischer Schaltkreis, der einen mittels Verwendung eines Identifikators gesicherten Testmodus umfasst, und zugehöriges Verfahren
Electronic circuit comprising a test mode secured by using an identifier, and associated method.

(30) Priorité: 15.02.2006 FR 0601304
(43) Date de publication de la demande: 22.08.2007
(73) Titulaire: STMicroelectronics S.A., 92120 Montrouge (FR)
(72) Inventeur: Bancel, Frédéric c/o STMICROELECTRONICS S.A., 57070, METZ (FR); Hely, David c/o STMICROELECTRONICS S.A., 57070, METZ (FR)
(74) Mandataire: Bouchet, Geneviève

(56) Documents cités:
- EP-A1- 1 560 031
- US-A1- 2004 133 832
- LEE J ET AL: "Securing Scan Design Using Lock and Key Technique" DEFECT AND FAULT TOLERANCE IN VLSI SYSTEMS, 2005. DFT 2005. 20TH IEEE INTERNATIONAL SYMPOSIUM ON MONTEREY, CA, USA 03-05 OCT. 2005, PISCATAWAY, NJ, USA,IEEE, 3 octobre 2005 (2005-10-03), pages 51-62, XP010856599 ISBN: 0-7695-2464-8

## Description

L'invention concerne, de façon générale, les circuits électroniques intégrés synchrones munis de moyens de logique combinatoire, de bascules, et de moyens de test.

Plus précisément, l'invention concerne un circuit électronique comprenant une pluralité de cellules configurables configurées :
- dans un état fonctionnel dans lequel les cellules configurables sont fonctionnellement reliées à des cellules logiques avec lesquelles elles coopèrent pour former au moins un circuit logique, si un signal de commande de chaînage est dans un premier état, ou
- dans un état chaîné dans lequel les cellules configurables sont fonctionnellement connectées en chaîne pour former un registre à décalage.

Il est aujourd'hui bien connu de vérifier le fonctionnement correct des éléments fonctionnels d'un circuit intégré en imposant et / ou en déterminant, à des instants prédéfinis, des valeurs de données présentes en certains points internes de ce circuit intégré. Une telle technique de test des chemins internes d'un circuit intégré (désignée par "scanpath" ou "internal scan method" en langue anglaise) est par exemple décrite dans la publication de M. Williams et J. Angel, intitulée "Enhancing Testability of LSI Circuits Via Test Points and Additional Logic, IEEE Transactions on Computers, vol. C-22, no.1; Janvier 1973".

Selon cette technique, chacune des bascules du circuit logique, dont il est utile de connaître l'état et / ou d'imposer le contenu durant le fonctionnement standard du circuit intégré, est dotée à son entrée d'un multiplexeur. Les différentes bascules et les multiplexeurs qui leur sont associés constituent ainsi autant de cellules configurables dont les accès sont contrôlés par ces multiplexeurs.

Les multiplexeurs de ces différentes cellules configurables sont collectivement commandés par un contrôleur d'accès ou "contrôleur TAP" ("TAP" pour "Test Access Port" en langue anglaise) qui, en fonction d'un signal de commande définissant un mode de fonctionnement choisi, utilise cet ensemble de cellules configurables soit comme un circuit fonctionnel standard, intégré au circuit logique qu'il forme avec les cellules logiques, soit comme un circuit de test.

Pour ce faire, le contrôleur TAP reçoit sur différents conducteurs de commande, et / ou adresse sur différents conducteurs de commande par lesquels il est relié aux différentes cellules configurables, des signaux de commande, tels qu'un signal de commande de mode, un signal de commande de chaînage ou encore un signal de commande de propagation de données, qui autorisent à modifier et / ou modifient les chemins de circulation des données au sein du circuit intégré et qui permettent ainsi la capture de ces données par le contrôleur, en vue de leur analyse ultérieure.

En mode de fonctionnement standard, le contrôleur TAP pilote donc les multiplexeurs des cellules configurables de manière que les bascules de ces cellules soient connectées à des cellules logiques environnantes pour définir un ou plusieurs sous-ensembles fonctionnels du circuit intégré.

Dans le mode de test, qui est normalement déclenché à réception par le contrôleur TAP d'un signal de commande de passage en mode de test, ce contrôleur produit un signal de commande de chaînage pour connecter en série les bascules des cellules configurables de manière à former un registre à décalage.

Ce registre comporte notamment une entrée série et une sortie série respectivement connectées à une sortie et à une entrée du contrôleur TAP, ainsi qu'une entrée d'horloge recevant un signal de propagation pour cadencer le flot de données circulant dans le registre à décalage.

Dans un premier temps, le contrôleur TAP charge en série des données dans les bascules des cellules configurables par l'entrée du registre à décalage que forment ces cellules configurables.

Puis, le contrôleur TAP change la commutation des multiplexeurs pour former le circuit fonctionnel, et commande l'exécution d'un ou plusieurs cycles du signal de propagation par ce circuit fonctionnel. Dans cette phase, les données chargées dans les bascules des cellules configurables sont traitées par le circuit fonctionnel.

Le contrôleur change alors une nouvelle fois la commutation des multiplexeurs pour former à nouveau le registre à décalage et récupère, en série sur la sortie de ce registre à décalage, les données mémorisées dans les bascules des cellules configurables durant le dernier cycle du signal de propagation.

En dépit de l'intérêt confirmé de cette technique de test, son application pratique peut en certaines circonstances s'avérer problématique, notamment sur les circuits intégrés qui traitent des données secrètes.

En effet, dans la mesure où l'activation du mode de test peut permettre à un fraudeur de lire le contenu des bascules des cellules configurables, cette technique de test présente a priori l'inconvénient de rendre de tels circuits très vulnérables à une utilisation frauduleuse.

Par exemple, en stoppant à divers moments un processus de chargement interne de données secrètes dans le circuit intégré et en déchargeant le contenu du registre à décalage, un fraudeur pourra obtenir des informations sur des données secrètes, voire les reconstituer.

En activant le mode de test, un fraudeur pourra également accéder en écriture aux bascules des cellules configurables pour insérer des données frauduleuses, ou bien pour placer le circuit intégré dans une configuration non autorisée. Il pourra ainsi par exemple accéder à un registre contrôlant un organe sécuritaire tel qu'un capteur pour le désactiver. Il pourra également injecter une donnée erronée en vue d'obtenir de l'information sur une donnée secrète.

La fraude peut en fait adopter deux stratégies différentes : la première consiste à prendre le contrôle du contrôleur TAP et à observer sur les plots externes le contenu des cellules du registre à décalage ; la seconde consiste à prendre le contrôle des cellules configurables en les excitant par micro-sondage de manière à simuler le pilotage de ces cellules par les signaux de commande qu'émet le contrôleur TAP.

On connaît notamment du document D1 (demande française FR 05/07282, correspondant à EP 1 742 075 A1) un circuit électronique conçu pour faire échec à une tentative de fraude. Dans D1, après être entrée dans le mode de test, un identifiant de l'utilisateur doit être entré. Si l'identifiant est correct, des données de test peuvent être entrées dans le registre à décalage. Sinon, une alerte est activée et le circuit sort du mode de test. Pour cela, le circuit électronique comprend, en complément des éléments décrits ci-dessus, un circuit de détection pour, si le signal de commande de chaînage est actif, vérifier le contenu du registre à décalage au bout du temps T1 nécessaire à l'entrée de l'identifiant dans le registre.

Selon la solution de D1, l'identifiant doit être entré à chaque activation du signal de commande de chaînage, avant de pouvoir entrer ou sortir des données du registre à décalage. Ceci devient vite contraignant pour des procédures de test plus ou moins longues au cours desquels on est amené à entrer et / ou sortir des données plusieurs fois. De plus, du fait de cette difficulté, on utilise en pratique des identifiants relativement courts : ils sont plus rapides à entrer dans le registre, mais aussi plus faciles à trouver pour un fraudeur. Enfin, comme l'entrée de l'identifiant se fait lorsque les cellules configurables sont chaînées, l'entrée de l'identifiant entraîne la sortie du contenu initial du registre qui peut éventuellement inclure des données à protéger d'un fraudeur.

On connaît également par le document EP 1 560 031 une pluralité de cellules configurables susceptibles d'être fonctionnellement reliées à des cellules logiques avec lesquelles elles coopèrent pour former au moins un circuit logique dans un premier mode de fonctionnement, et d'être agencées en registre à décalage dans un mode de test. Un circuit de diversion est formé avec les cellules configurables lorsqu'une commande de lecture ou d'écriture est appliquée aux cellules configurables sans qu'une clé d'identification n'ait été fournie à un module de contrôle.

L'invention a pour but un circuit électronique protégé contre les attaques et ne présentant pas les inconvénients des circuits connus.

Le circuit selon l'invention comprend, comme les circuits antérieurs, une pluralité de cellules configurables susceptibles d'être fonctionnellement reliées à des cellules logiques avec lesquelles elles coopèrent pour former au moins un circuit logique si un signal de commande de chaînage est dans un premier état.

Le circuit selon l'invention comprend également un circuit d'interconnexion comprenant une pluralité de cellules de connexion comprenant chacun :
- une première entrée de données connectée à une sortie de données d'une première cellule configurable,
- une sortie de données connectée à une entrée de test d'une deuxième cellule configurable de rang supérieur au rang de la première cellule configurable, et
- un moyen de combinaison et de connexion adapté pour relier la première entrée de données de la cellule de connexion à la sortie de la cellule de connexion si un signal d'authentification est dans un deuxième état et si le signal de commande de chaînage est dans un deuxième état, chaque cellule de connexion comprenant une deuxième entrée de données connectée à la sortie de données de la deuxième cellule configurable ou à la sortie de données d'une troisième cellule configurable de rang supérieur au rang de la deuxième cellule configurable, le moyen de combinaison et de connexion étant adapté en outre pour :
   ✔ combiner la première entrée de données de la cellule de connexion avec la deuxième entrée de données de la cellule de connexion et appliquer le résultat de la combinaison sur la sortie de la cellule de connexion si le signal d'authentification (COM) est dans un premier état,
le circuit électronique comprenant également un circuit de détection agencé pour, un temps T1 après un premier passage du signal de commande de chaînage dans le deuxième état, mettre et maintenir le signal d'authentification dans le deuxième état si le contenu d'un ensemble de Y1 cellules configurables de la pluralité de cellules configurables correspond à une première valeur de référence.

Ainsi, lorsque le signal d'authentification est dans le premier état, le moyen de combinaison et de connexion relie fonctionnellement l'ensemble des cellules configurables en un registre contenant une contre-réaction et, lorsque le signal d'authentification est dans le deuxième état, le moyen de combinaison et de connexion relie fonctionnellement l'ensemble des cellules configurables en un registre à décalage de test.

On prévoit ainsi dans le circuit selon l'invention la possibilité de configurer les cellules configurables dans un état rebouclé dans lequel les dites cellules forment un registre contenant une contre-réaction (registre LFSR pour Linear Feedback Shift Register en anglais). Dans un tel registre contenant une contre-réaction, il est possible d'entrer des données telles qu'un identifiant. Les données sortant de ce registre contenant une contre-réaction sont par contre inexploitables par un fraudeur, car, dans cet état rebouclé, comme on le verra mieux par la suite, le contenu des cellules configurables est modifié au fur et à mesure du chargement de données dans les cellules configurables.

Pour tester un circuit selon l'invention, on réalise les étapes suivantes, consistant à, lorsque le signal de commande de chaînage est dans le deuxième état et le signal d'authentification est dans le premier état :
- entrer un identifiant dans les cellules configurables formant fonctionnellement le registre contenant une contre-réaction,
- vérifier un contenu des cellules configurables et
- au bout d'un temps prédéfini T1, activer le signal d'authentification si le dit contenu est égal à une valeur attendue.

De préférence, on réalise également avant une étape d'initialisation du contenu des cellules configurables.

Ainsi, dans le circuit selon l'invention, lors du premier passage en mode de test (activation du signal de commande de chaînage), le circuit passe tout d'abord dans un mode d'authentification, dans lequel les cellules configurables sont reliées par l'intermédiaire de cellules d'interconnexion pour former un registre contenant une contre-réaction et dans lequel l'utilisateur autorisé peut entrer en série des bits d'un identifiant. Puis, après vérification de l'identifiant, le signal d'authentification est activé et le circuit électronique passe dans le mode de test véritablement, dans lequel les cellules configurables sont fonctionnellement connectées en chaîne et forment un registre à décalage.

Le signal d'authentification reste actif, même si le signal de commande de chaînage change une ou plusieurs fois d'état. Ainsi, lorsque le signal de commande de chaînage change d'état, on passe directement de l'état fonctionnel à l'état chaîné (ou l'inverse), sans repasser par l'état rebouclé. Il n'est donc plus nécessaire d'entrer l'identifiant systématiquement avant l'entrée (ou la sortie) de chaque donnée dans le registre à décalage.

L'invention sera mieux comprise et d'autres caractéristiques et avantages apparaîtront à la lecture de la description qui va suivre, d'exemples de mise en oeuvre d'un circuit électronique selon l'invention. La description, faite à titre indicatif et nullement limitatif, est à lire en relation aux dessins annexés dans lesquels :
- la figure 1 est un schéma d'un circuit selon l'invention,
- la figure 2 détaille des éléments du circuit de la figure 1, et
- la figure 3 est une variante du circuit selon les figures 1 et 2.

Comme annoncé précédemment, l'invention concerne un circuit électronique doté de moyens de test internes.

Un tel circuit électronique comprend typiquement une pluralité de cellules logiques telles que les cellules 10 à 15, une pluralité de cellules configurables telles que les cellules 2a, 2b, ... 2x, 2y, 2z.

Le circuit électronique peut aussi éventuellement comprendre un circuit de commande tel qu'un contrôleur d'accès CTAP, qui peut aussi toutefois être externe au circuit électronique considéré. Ce contrôleur a notamment pour fonction d'émettre ou de recevoir des signaux de commande, tels que :
- un signal de commande de passage en mode de test TEST_MODE qui active le circuit de commande CTAP,
- un signal de commande de chaînage SCAN_ENABLE qui active l'entrée de test des cellules configurables,
- un signal d'initialisation RESET, qui initialise le contenu des cellules configurables, et
- un signal de commande CLK qui permet la propagation de données dans les cellules configurables.

Selon l'invention, le circuit comprend également un circuit d'interconnexion logique 200, et un dispositif de détection 300.

Chacune des cellules configurables 2a à 2z comprend :
- une entrée de données connectée à certaines des cellules logiques 10 à 15,
- une entrée de test connectée à la sortie d'une cellule configurable précédente ou à une sortie du circuit d'interconnexion 200,
- une sortie de données connectée d'une part à certaines des cellules logiques 10 à 15, et d'autre part à l'entrée de test d'une cellule configurable suivante ou à une entrée du circuit 200,
- une entrée d'horloge sur laquelle est appliqué le signal de propagation CLK,
- une entrée de commande sur laquelle est appliqué le signal de commande de chaînage SCAN_ENABLE,
- une entrée d'initialisation sur laquelle est appliqué le signal d'initialisation RESET.

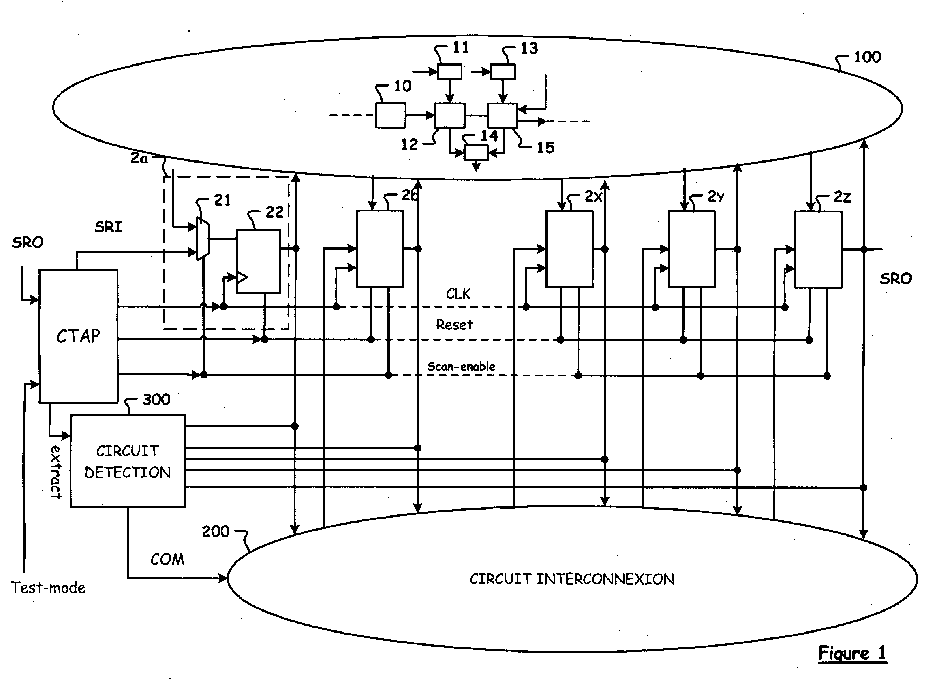

Chacune des cellules configurables 2a à 2z comprend également un multiplexeur 21 et une bascule 22 (par souci de clarté, seule la cellule 2a est détaillée sur la figure 1). Le multiplexeur 21 comprend deux entrées de données connectées respectivement à l'entrée de données et à l'entrée de test de la cellule configurable, une entrée de commande connectée à l'entrée de commande de la cellule configurable pour recevoir le signal SCAN_ENABLE, et une sortie. La bascule 22 comprend quant à elle une entrée de donnée D connectée à la sortie du multiplexeur 21, une entrée d'horloge, une entrée d'initialisation et une sortie connectées respectivement à l'entrée d'horloge, à l'entrée d'initialisation et à la sortie de données de la cellule configurable.

Lorsque le signal SCAN _ENABLE est dans un premier état logique (inactif), le multiplexeur 21 de chaque cellule configurable est configuré de sorte que l'entrée de donnée de la cellule soit active, c'est-à-dire de sorte que la dite entrée de données de la cellule soit connectée à l'entrée de données de la bascule 22. Les cellules configurables 2a à 2z adoptent dans ce cas un mode de fonctionnement standard, dans lequel elles sont fonctionnellement reliées (par l'intermédiaire de leur entrée de données et de leur sortie de données) à certaines au moins des cellules logiques 10 à 15 avec lesquelles elles coopèrent pour former un circuit logique 100.

Lorsque le signal SCAN_ENABLE est dans un deuxième état logique (actif), le multiplexeur 21 de chaque cellule configurable est configuré de sorte que l'entrée de test de la cellule soit active, c'est-à-dire de sorte que la dite entrée de test de la cellule soit connectée à l'entrée de données de la bascule 22.

Le circuit d'interconnexion logique 200 comprend quant à lui des entrées de données connectées aux sorties de données des cellules configurables, et des sorties de données connectées à des entrées de test des cellules configurables. Il comprend également une entrée de commande, sur laquelle est appliqué le signal d'authentification COM.

Si le signal d'authentification COM est dans un premier état (inactif), le circuit d'interconnexion relie les cellules configurables pour former fonctionnellement un registre contenant une contre-réaction. Le circuit est ainsi dans un mode de fonctionnement intermédiaire entre le mode de fonctionnement standard et le mode de test.

Si le signal d'authentification est dans un deuxième état (actif), le circuit d'interconnexion relie les cellules configurables fonctionnellement en chaîne pour former un registre à décalage. Le circuit est alors véritablement en mode de test.

Dans le mode de test, le registre à décalage 2a à 2z présente notamment une entrée de données SRI pilotée par une sortie du circuit de commande CTAP, une sortie de données SRO, reliée à une entrée du circuit de commande CTAP, et une entrée d'horloge pour recevoir le signal de propagation CLK propre à cadencer le flot de données dans ce registre à décalage.

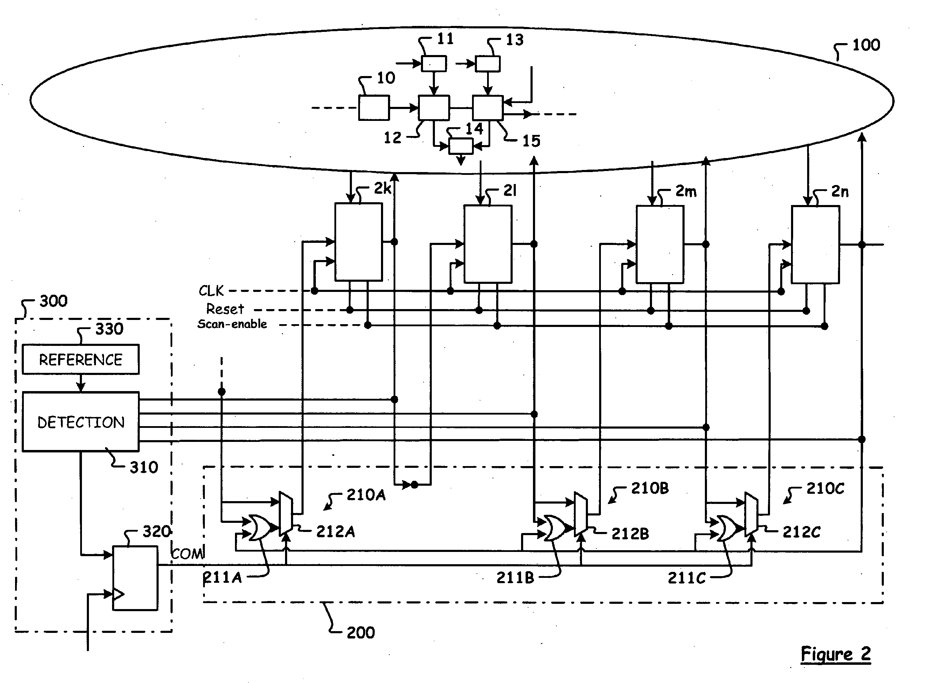

Sur la figure 2 sont notamment détaillées des réalisations du circuit d'interconnexion logique 200 et du circuit de détection 300.

Le circuit d'interconnexion a pour fonction de :
- relier les cellules configurables de manière approprié pour former un registre contenant une contre-réaction si le signal d'authentification COM est dans un premier état (inactif), ou
- chaîner les cellules configurables pour former un registre à décalage si le signal d'authentification COM est dans un deuxième état (actif).

Dans l'exemple particulier de réalisation de la figure 2, le circuit d'interconnexion logique 200 est approprié pour, lorsque le signal COM est actif :
- associer une partie des cellules configurables (dans l'exemple les cellules 2k, 21, 2m et 2n) sous la forme d'un dispositif rebouclé de X1 bits (dans l'exemple X1 = 4 bits), dont une entrée de données est reliée à la sortie de données de la cellule 2j précédente et dont la sortie de données est reliée à l'entrée de test de la cellule 2o suivante,
- chaîner les cellules configurables 2a à 2j,
- chaîner les cellules configurables 2o à 2z.

L'ensemble des cellules configurables ainsi associées forme un registre contenant une contre-réaction.

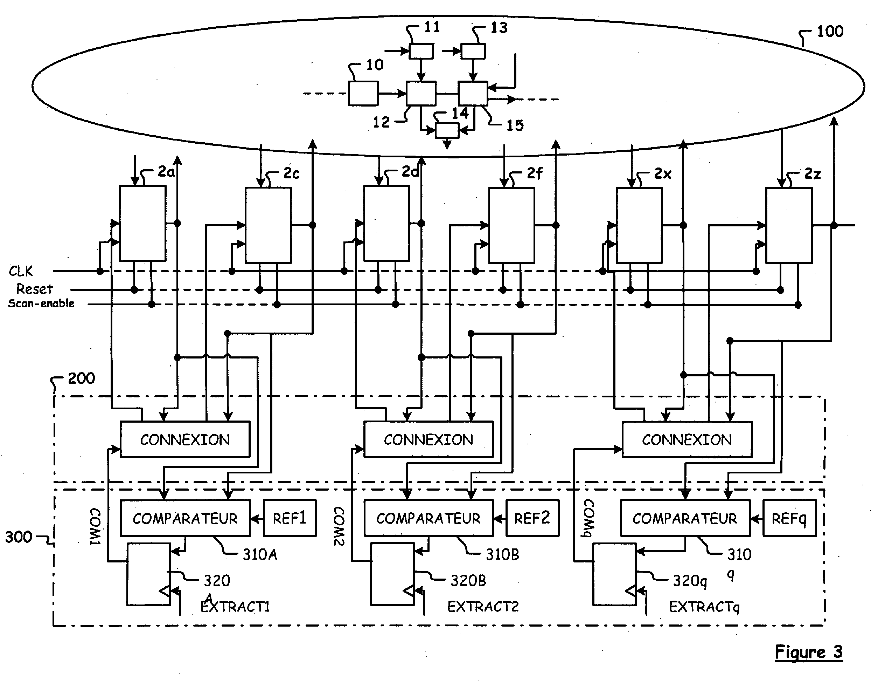

Le circuit d'interconnexion 200 comprend une pluralité de cellules de connexion (dans l'exemple représenté figure 2, 3 cellules de connexion 210a, 210b, 210c) comprenant chacune :
- une première entrée de données connectée à une sortie de données d'une première cellule configurable (dans l'exemple, la cellule configurable 2j non représentée pour la cellule de connexion 210a, la cellule configurable 21 pour la cellule de connexion 210b et la cellule configurable 2m pour la cellule de connexion 210c),
- une sortie de données connectée à une deuxième cellule configurable de rang supérieur au rang de la première cellule configurable (dans l'exemple la cellule configurable 2k pour la cellule de connexion 210a, la cellule configurable 2m pour la cellule de connexion 210b et la cellule configurable 2n pour la cellule de connexion 210c),
- une deuxième entrée de données connectée à la sortie de données de la deuxième cellule configurable ou à la sortie de données d'une troisième cellule configurable de rang supérieur à un rang de la deuxième cellule configurable (dans l'exemple la troisième cellule configurable est la cellule configurable 2n pour les cellules de connexion 210a, 210b et 210c), et
- un moyen de combinaison et de connexion pour :
   ✔ combiner la première entrée de données de la cellule de connexion avec la deuxième entrée de données de la cellule de connexion et appliquer le résultat de la combinaison sur la sortie de la cellule de connexion si le signal d'authentification COM est dans le premier état, ou
   ✔ relier la première entrée de données de la cellule de connexion à la sortie de la cellule de connexion si le signal d'authentification COM est dans le deuxième état.

Le moyen de combinaison et de connexion comprend dans l'exemple de la figure 2 :
- une porte logique 211a, 211b ou 211c, ici de type OU-Exclusif, comprenant deux entrées connectées respectivement à la première entrée de données et à la deuxième entrée de données de la cellule de connexion,
- un multiplexeur 212a, 212b ou 212c comprenant deux entrées connectées respectivement à la première entrée de données et à une sortie de la porte logique.

La sortie de données de la cellule 2k est reliée directement à l'entrée de données de la cellules 21.

Lorsque le signal COM est inactif (avant authentification), les deuxièmes entrées des multiplexeurs 212a, 212b, 212c sont sélectionnées : la sortie de la cellule 2n est ainsi rebouclée sur les entrées des cellules précédentes 2k, 2m, 2n, par l'intermédiaire des portes 211a, 211b, 211c pour former un dispositif rebouclé ou registre LFSR (Linear Feedback Shift Register en anglais).

Les registres LFSR sont bien connus ; ils sont couramment utilisés par exemple pour effectuer des divisions polynomiales pour chiffrer ou déchiffrer un message d'entrée, ou bien pour générer des nombres pseudo-aléatoires. Ils sont toujours réalisés sur le principe du schéma de la figure 2 : la sortie de la dernière cellule du registre est réinjectée à l'entrée d'une ou plusieurs cellules du registre en combinaison avec la sortie d'une cellule précédente par l'intermédiaire d'une porte logique. La position des cellules d'interconnexion (portes logiques) dépend du polynôme mis en oeuvre par le dispositif rebouclé (par exemple dans le cas de la figure 2, le polynôme x³ + x + 1 est mis en oeuvre).

Lorsque le signal COM est actif (après authentification), les premières entrées des multiplexeurs sont reliées directement aux sorties des cellules configurables, de sorte que les dites cellules configurables sont chaînées en un registre à décalage (non rebouclé). Le mode de test est ainsi actif.

Le circuit de détection 300 a pour fonction de détecter les données présentes sur les sorties de données d'une partie des cellules configurables, et de produire le signal d'authentification si, au bout d'un temps T1, les dites données sont égales à une valeur de référence.

Dans l'exemple représenté sur la figure 2, le circuit de détection 300 comprend un comparateur 310, une bascule 320 et un registre 330.

Le comparateur comprend Y1 (dans l'exemple représenté, Y1 = 4) entrées de données de un bit, chacune connectée à une sortie de données de l'une des cellules 2k, 21, 2m, 2n, et une entrée de données de Y1 bits connectée au registre 330 dans lequel est mémorisé une valeur de référence. Une sortie de données du comparateur est connectée à une entrée de données de la bascule 320 de type D, comprenant également une entrée de commande sur laquelle est appliqué le signal EXTRACT et une sortie connectée à l'entrée de commande du dispositif d'interconnexion logique.

Le signal EXTRACT est produit par le circuit de commande CTAP, un temps T1 après la première activation du signal SCAN_ENABLE. Le temps T1 correspond au temps de chargement dans les cellules configurables de l'identifiant de l'utilisateur. T1 est égal à p fois la période du signal CLK, p étant la taille de l'identifiant.

Dans une variante, le circuit CTAP produit le signal EXTRACT lors de la première désactivation du signal SCAN_ENABLE, qui correspond à la fin du chargement de l'identifiant.

La taille de l'identifiant peut être au choix inférieure ou supérieure au nombre de cellules configurables 2a à 2z. La sécurité globale du circuit augmente en pratique avec la taille de l'identifiant.

Le fonctionnement du circuit de détection est le suivant. Le comparateur 310 compare le contenu des cellules configurables 2k, 21, 2m, 2n avec la valeur de référence et produit un signal actif si les deux sont égaux ou inactif sinon. Lorsqu'elle reçoit le signal EXTRACT, la bascule transmet et maintient sur sa sortie le signal COM produit par le comparateur.

Le fonctionnement global du circuit selon l'invention va maintenant être décrit, en combinaison avec le procédé selon l'invention.

Initialement, tous les signaux TEST_MODE, SCAN_ENABLE, RESET, CLK, COM sont inactifs.

Pour lancer un test, un signal TEST _MODE de commande de passage en mode de test doit d'abord être adressé au circuit de commande CTAP.

Lors de la première activation du signal TEST_MODE, le circuit CTAP produit tout d'abord un signal RESET actif, qui va initialiser le contenu de toutes les cellules configurables 2a à 2z, puis produit le signal SCAN_ENABLE actif, qui va commander les multiplexeurs 21 de manière appropriée pour activer les entrées de test des cellules configurables. Comme le signal COM est inactif, les cellules configurables sont reliées au dispositif d'interconnexion pour former un registre contenant une contre-réaction.

Puis, par émission du signal de commande de propagation CLK, le circuit de commande CTAP charge en série un identifiant dans les bascules 22 de ces cellules configurables à travers l'entrée SRI du registre contenant une contre-réaction. Le comparateur 310 compare le contenu des cellules configurables avec la valeur de référence.

Au bout du temps T1, le circuit CTAP produit le signal EXTRACT et, si l'identifiant est correct (ie si le contenu des cellules 2a à 2z est égal à la valeur attendue mémorisée dans le registre 330), le comparateur 310 produit un signal COM actif que la bascule 320 retransmet sur sa sortie. (Le signal COM reste inactif si l'identifiant n'est pas correct).

Le signal COM configure les multiplexeurs 212a, 212b, 212c de sorte à ce que les cellules 2a à 2z soient chaînées. L'utilisateur est ainsi authentifié et le mode de test est ainsi activé.

Puis, par émission du signal de commande de propagation CLK, le circuit de commande CTAP charge en série des données de test dans les bascules 22 des cellules configurables à travers l'entrée SRI du registre contenant une contre-réaction.

Puis, par désactivation du signal de commande de chaînage SCAN_ENABLE, le circuit de commande CTAP reconfigure les cellules configurables 2a à 2z en élément fonctionnel du circuit logique 100 et commande l'exécution d'un ou plusieurs cycles du signal de propagation CLK par cet élément fonctionnel, qui traite les données de test.

Par réactivation du signal de commande de chaînage SCAN_ENABLE (le signal COM restant inchangé), le circuit de commande CTAP reconfigure à nouveau les cellules configurables 2a à 2z en registre à décalage. Enfin, par émission du signal de commande de propagation CLK, le circuit de commande CTAP récupère, à la sortie SRO de ce registre, les données mémorisées dans les bascules 22 et issues du traitement des données de test par le circuit logique 100.

Le signal SCAN_ENABLE peut ensuite être désactivé puis réactivé à volonté, sans modification du signal COM.

A noter que, dans le circuit de l'invention, il est nécessaire d'initialiser les cellules configurables avant l'entrée de l'identifiant puisque le contenu des cellules avant l'entrée de l'identifiant vient modifier le contenu des cellules au fur et à mesure de l'entrée de l'identifiant. En conséquence, un fraudeur qui tenterait d'introduire un identifiant ne pourrait espérer obtenir en retour une information sur un contenu résiduel des cellules avant l'entrée de l'identifiant.

Dans l'exemple de la figure 2, on a représenté une variante du circuit de l'invention dans laquelle :
- le circuit d'interconnexion logique est approprié, lorsque le signal COM est actif, pour former un registre contenant une contre-réaction de la manière suivante :
   ✔ former un dispositif rebouclé avec quatre cellules configurables 2k, 21, 2m et 2n et des cellules d'interconnexion appropriées,
   ✔ chaîner les cellules précédentes 2a à 2j (non représentées figure 2) et relier la sortie de la cellule 2j à l'entrée de données du dispositif rebouclé,
   ✔ chaîner les cellules suivantes 2o à 2z (non représentées figure 2) et relier la sortie du dispositif rebouclé à l'entrée de test de la cellule 2o.
- le circuit de détection est approprié pour tester le contenu des cellules configurables du dispositif rebouclé et produire le signal d'authentification si ce contenu est égal à une valeur attendue.

Mais bien d'autres solutions sont envisageables pour la réalisation du circuit d'interconnexion.

Par exemple, il est possible d'utiliser un circuit d'interconnexion approprié pour, lorsque le signal COM est actif, former un dispositif rebouclé avec toutes les cellules configurables 2a à 2z (dans ce cas, le dispositif rebouclé forme directement le registre contenant une contre-réaction). Ceci devient toutefois rapidement difficile à mettre en oeuvre, notamment pour des circuits comprenant un grand nombre de cellules configurables. La difficulté de réalisation et la taille du circuit d'interconnexion logique augmentent fortement avec le nombre de cellules configurables associées ensembles dans le dispositif rebouclé.

Il est également possible de regrouper toutes les cellules (ou seulement une partie d'entre elles) par paquets de plusieurs cellules adjacentes et d'utiliser un circuit d'interconnexion approprié pour former un dispositif rebouclé pour chaque paquet de cellules, et associer en série les différents dispositifs rebouclés ainsi formés pour réaliser le registre contenant une contre-réaction. On prévoira dans ce cas de préférence un circuit de détection pour chaque paquet de cellules configurables. Les paquets peuvent comprendre tous un même nombre de cellules configurables, mais ceci n'est pas indispensable. Dans un exemple d'un circuit comprenant un total de 1000 à 2000 cellules configurables, on pourra regrouper les cellules par paquet de 50 cellules. Ce mode réalisation est préférable au précédent, car le circuit d'interconnexion logique nécessaire à la réalisation de plusieurs dispositifs rebouclés comprenant un petit nombre de cellules configurables est plus facile et moins coûteux (en terme de surface de silicium notamment) à réaliser qu'un circuit d'interconnexion nécessaire à la réalisation d'un seul dispositif rebouclé comprenant globalement le même nombre de cellules configurables.

Un exemple d'un tel mode de réalisation est représenté sur la figure 3.

La pluralité de cellules configurables 2a à 2z a été répartie en q paquets de cellules : le premier paquet comprend les cellules 2a à 2c, le deuxième paquet comprend les cellules 2d à 2f, ..., le q-ième paquet comprend les cellules 2x à 2z. A chaque paquet de cellules est associé un dispositif d'interconnexion 200a à 200q, approprié pour, en fonction d'un signal COMa à COMq, relier les cellules configurables du paquet associé soit en un dispositif rebouclé soit en chaîne.

A chaque dispositif d'interconnexion 200a à 200q est associé un dispositif de détection 300a à 300q pour détecter le contenu des cellules configurables du paquet de cellules associé lorsqu'il reçoit un signal EXTRACTa, à EXTRACTq, le comparer avec une valeur attendue REFa à REFq et produire le signal d'authentification COMa à COMq si au bout d'un temps Ta à Tq (éventuellement des temps Ta à Tq différents les uns des autres), le contenu des cellules détectées est différent de la valeur attendue associée REFa à REFq.

Les signaux EXTRACTa à EXTRACTq sont produits par le circuit CTAP à partir du signal SCAN_ENABLE.

Dans une première variante, le signal EXTRACTa est produit un temps Ta après la première activation du signal SCAN_ENABLE, le signal EXTRACTb est produit un temps Tb après la première activation du signal SCAN_ENABLE, ... le signal EXTRACTq est produit un temps Tq après la première activation du signal SCAN_ENABLE, les temps Ta, Tb, ... Tq étant croissants et le temps TQ correspondant de préférence à la fin du chargement de l'identifiant dans les cellules configurables. Le signal SCAN_ENABLE est dans ce cas maintenu actif pendant tout le temps de chargement de l'identifiant ; l'extraction et la vérification du contenu des bascules se fait en parallèle ; l'extraction et la vérification du contenu des bascules est de préférence interrompue dès qu'un des signaux COMa à COMq n'est pas activé au bout du temps Ta à Tq associé.

Dans une deuxième variante, au bout du temps Ta après la première activation du signal SCAN_ENABLE, le signal SCAN_ENABLE est désactivé et le signal EXTRACTa est produit, ce qui interrompt le chargement de l'identifiant et active le circuit de détection 300a ; Ta est choisi supérieur ou égal au temps de chargement du début de l'identifiant dans le premier paquet de cellules configurables. Si le circuit de détection 300a produit le signal COMa actif, alors le signal SCAN_ENABLE est réactivé (deuxième activation) et le chargement de l'identifiant reprend ; au bout d'un temps Tb après la deuxième activation de SCAN_ENABLE, le signal SCAN_ENABLE est désactivé et le signal EXTRACTb est produit, ce qui interrompt le chargement de l'identifiant et active le circuit de détection 300b ; Tb est choisi supérieur ou égal au temps de chargement du début de l'identifiant dans le deuxième paquet de cellules configurables. Si le circuit de détection 300b produit le signal COMb actif, alors le signal SCAN_ENABLE est réactivé (troisième activation) et le chargement de l'identifiant reprend ; ... au bout d'un temps Tq après la (q-1)^{-ième} activation de SCAN_ENABLE, le signal SCAN_ENABLE est désactivé et le signal EXTRACTq est produit, le chargement de l'identifiant est terminé et le circuit de détection 300q est activé. Tq est choisi égal au temps de chargement des derniers bits de l'identifiant dans les cellules configurables.

Tel que représenté sur la figure 3, chaque dispositif d'interconnexion 200a à 200q reçoit un signal d'authentification COMa à COMq produit par un dispositif de détection associé 300a à 300q.

Dans une deuxième variante (non représentée), chaque dispositif d'interconnexion 200a à 200q reçoit plusieurs des signaux d'authentification COMa à COMq (éventuellement tous les signaux, mais pas nécessairement) et, en fonction des signaux qu'il reçoit, relier les cellules configurables du paquet associé :
- soit en un dispositif rebouclé si au moins un des signaux est inactif
- soit en chaîne sinon.

Selon une troisième variante (non représentée), on prévoit un moyen pour combiner les signaux COMa à COMq, et produire un signal résultant COM inactif si l'un au moins des signaux COMa à COMq est inactif, le signal résultant COM étant ensuite appliqué à tous les dispositif de détection. Cette variante est toutefois moins sécurisée que la variante précédente dans le mesure où le signal résultant COM est susceptible de subir une attaque par micro-sondage.

D'autres solutions sont également envisageables pour la réalisation du circuit de détection.

Par exemple, le circuit de détection peut être adapté pour détecter le contenu de toutes les cellules configurables, y compris éventuellement celles qui n'ont pas une entrée rebouclée.

Par ailleurs, les cellules configurables impliquées dans un dispositif rebouclé et les cellules configurables dont on détecte le contenu ne sont pas obligatoirement les mêmes.

De manière générale, un circuit selon l'invention comprend :
- un moyen d'interconnexion, pour former un registre à contre-réaction comprenant un ou plusieurs dispositifs rebouclés (chacun incluant plusieurs cellules configurables) associés en série avec éventuellement d'autres cellules configurables,
- et de préférence un moyen de détection, pour détecter le contenu de tout ou partie des cellules configurables au bout d'un temps T1 et produire un signal d'authentification si le dit contenu est égal à une valeur de référence.

Si le signal d'authentification n'est pas actif après le temps T1, le moyen d'interconnexion n'autorise pas l'association en chaîne des cellules configurables : le mode de test n'est pas activé.

Selon une variante, le signal COM (ou les signaux COMa à COMq) est également fourni au circuit de commande CTAP qui peut interdire la continuation du chargement de données dans les cellules configurables. Pour cela, le circuit CTAP peut :
- réinitialiser les cellules configurables pour effacer leur contenu et / ou
- changer l'état du signal de commande SCAN_ENABLE pour reconfigurer les cellules dans le mode de fonctionnement standard, et / ou
- inhiber le signal CLK de propagation de données pour mettre le circuit dans un état de blocage total.

## Revendications

1. Circuit électronique comprenant une pluralité de cellules configurables (2a, ..., 2z) susceptibles d'être fonctionnellement reliées à des cellules logiques (10 à 15) avec lesquelles elles coopèrent pour former au moins un circuit logique si un signal de commande de chaînage (SCAN_ENABLE) est dans un premier état,
le circuit électronique comprenant également un circuit d'interconnexion (200) comprenant une pluralité de cellules de connexion (210a, 210b, 210c) comprenant chacun :
• une première entrée de données connectée à une sortie de données d'une première cellule configurable,
• une sortie de données connectée à une entrée de test d'une deuxième cellule configurable de rang supérieur au rang de la première cellule configurable, et
un moyen de combinaison et de connexion adapté pour relier la première entrée de données de la cellule de connexion à la sortie de la cellule de connexion si un signal d'authentification (COM) est dans un deuxième état et si le signal de commande de chaînage est dans un deuxième état, **caractérisé en ce que** chaque cellule de connexion (210a, 210b, 210c) comprend une deuxième entrée de données connectée à la sortie de données de la deuxième cellule configurable ou à la sortie de données d'une troisième cellule configurable de rang supérieur au rang de la deuxième cellule configurable, le moyen de combinaison et de connexion étant adapté en outre pour combiner la première entrée de données de la cellule de connexion avec la deuxième entrée de données de la cellule de connexion et appliquer le résultat de la combinaison sur la sortie de la cellule de connexion si le signal d'authentification (COM) est dans un premier
état, si un signal de commande de chaînage est dans le deuxième état, ,
et **en ce que** le circuit électronique comprend également un circuit de détection (300) agencé pour, un temps T1 après un premier passage du signal de commande de chaînage (SCAN_ENABLE) dans un deuxième état, mettre et maintenir le signal d'authentification (COM) dans le deuxième état si le contenu d'un ensemble de Y1 cellules configurables de ladite pluralité de cellules configurables (2a,..., 2z) correspond à une première valeur de référence (REF1).

2. Circuit selon la revendication 1, dans lequel le moyen de combinaison et de connexion comprend :
• une porte logique (211a, 211b, 211c) comprenant deux entrées connectées respectivement à la première entrée de données et à la deuxième entrée de données de la cellule de connexion,
• un multiplexeur (212a, 212b, 212c) comprenant deux entrées connectées respectivement à la première entrée de données de la cellule de connexion et à une sortie de la porte logique.

3. Circuit électronique selon la revendication 1, dans lequel le circuit de détection (300) comprend:
• un comparateur (310) pour comparer le contenu des Y1 cellules configurables avec la première valeur de référence et mettre le signal d'authentification dans le deuxième état si le contenu des Y1 cellules configurables correspond à la première valeur de référence, et
• un circuit de validation (320) pour transmettre le signal d'authentification au circuit d'interconnexion après le temps T1.

4. Circuit électronique selon l'une des revendications précédentes, dans lequel la pluralité de cellules configurables est découpée en une pluralité de paquets de cellules configurables, et dans lequel le circuit d'interconnexion comprend une pluralité de paquets de cellules de connexion associée à la pluralité paquets de cellules configurables pour former une pluralité de registres rebouclés associés en série pour former un registre contenant une contre-réaction si le signal d'authentification est dans le premier état.

5. Circuit électronique selon la revendication précédente, comprenant également une pluralité de circuits de détection (300a à 300q), chacun associé à un paquet de cellules configurables et à un paquet de cellules de connexion, et chaque circuit de détection étant agencé pour, un temps associé .(Ta à Tq) après un premier passage du signal de commande de chaînage (SCAN_ENABLE) dans le deuxième état, mettre le signal d'authentification (COM) dans le deuxième état si le contenu du paquet de cellules configurables associé correspond à une valeur de référence associée (REFa à REFq).

6. Procédé de test d'un circuit électronique comprenant une pluralité de cellules configurables (2a, ..., 2z) configurées en fonction d'un signal de commande de chaînage (SCAN_ENABLE) et d'un signal d'authentification (COM):
• si le signal de commande de chaînage est dans un premier état, dans un état fonctionnel dans lequel les cellules configurables sont fonctionnellement reliées à des cellules logiques (10 à 15) avec lesquelles elles coopèrent pour former au moins un circuit logique,
• si le signal de commande de chaînage est dans un deuxième état, et
✔ si le signal d'authentification est dans un premier état, dans un état rebouclé dans lequel les cellules configurables sont fonctionnellement reliées à des cellules d'interconnexion pour former un registre contenant une contre-réaction,
✔ si le signal d'authentification est dans un deuxième état, dans un état chaîné dans lequel les cellules configurables sont fonctionnellement connectées en chaîne pour former un registre à décalage.
le procédé étant **caractérisé en ce qu'**il comprend les étapes suivantes, consistant à, lorsque le signal de commande de chaînage (SCAN_ENABLE) est dans le deuxième état et le signal d'authentification est dans le premier état :
• entrer un identifiant dans les cellules configurables formant fonctionnellement le registre contenant une contre-réaction,
• vérifier un contenu d'une partie desdites cellules configurables et
• mettre et maintenir le signal d'authentification dans le deuxième état si, au bout d'un temps prédéfini, le dit contenu est égal à une valeur attendue.

7. Procédé selon la revendication précédente, comprenant également une étape d'initialisation du contenu des cellules configurables.

## Claims

1. Electronic circuit comprising a number of configurable cells (2a, ..., 2z) liable to be operationally connected to logic cells (10 to 15) with which they cooperate to form at least one logic circuit if a chaining control signal (SCAN_ENABLE) is in a first state,
the electronic circuit also comprising an interconnection circuit (200) comprising a number of connecting cells (210a, 210b, 210c) each comprising:
• a first data input connected to a data output of a first configurable cell,
• a data output connected to a test input of a second configurable cell of rank higher than the rank of the first configurable cell, and
combination and connection means adapted to connect the first data input of the connection cell to the output of the connection cell if an authentification signal (COM) is in a second state and if the chaining control signal is in a second state, **characterised in that** each connection cell (210a, 210b, 210c) comprises a second data input connected to the data output of the second configurable cell or to the data output of a third configurable cell of rank higher than the rank of the second configurable cell, the combination and connection means being in addition adapted to combine the first data input of the connection cell with the second data input of the connection cell and to apply the result of the combination to the output of the connection cell if the authentification signal (COM) is in a first state, if a chaining control signal is in the second state,
and **in that** the electronic circuit also comprises a detection circuit (300) arranged to, a time T1 after a first change of the chaining control signal (SCAN_ENABLE) into a second state, place and maintain the authentification signal (COM) in the second state if the content of an assembly of Y1 configurable cells of the said number of configuration cells (2a, ..., 2z) corresponds to a first reference value (REF1).

2. Circuit according to claim 1, where the combination and connection means comprises:
• a logic gate (211a, 211b, 211c) comprising two inputs connected respectively to the first data input and to the second data input of the connection cell,
• a multiplexer (212a, 212b, 212c) comprising two inputs connected respectively to the first data input of the connection cell and to an output of the logic gate.

3. Electronic circuit according to claim 1, where the detection circuit (300) comprises:
• a comparator (310) to compare the content of the Y1 configurable cells with the first reference value and to place the authentification signal in the second state if the content of the Y1 configurable cells corresponds to the first reference value, and
• a validation circuit (320) to transmit the authentification signal to the interconnection circuit after time T1.

4. Electronic circuit according to one of the previous claims, where the number of configurable cells is broken down into a number of configurable cell packets and where the interconnection circuit comprises a number of connection cell packets associated with the number of configurable cell packets to form a number of looped registers associated in series to form a register containing a counter-reaction if the authentification signal is in the first state.

5. Electronic circuit according to the previous claim, also comprising a number of detection circuits (300a to 300q), each associated with a configurable cell packet and a connection cell packet, and each detection circuit being arranged to, an associated time (Ta to Tq) after a first change of the chaining control signal (SCAN_ENABLE) into the second state, place the authentification signal (COM) in the second state if the content of the associated configuration cell packet corresponds to an associated reference value (REFa to REFq).

6. Test procedure for an electronic circuit comprising a number of configurable cells (2a, ..., 2z) configured according to a chaining control signal (SCAN_ENABLE) and an authentification signal (COM):
• if the chaining control signal is in a first state, in an operational state where the configurable cells are operationally connected to the logic cells (10 to 15) with which they cooperate to form at least one logic circuit,
• if the chaining control signal is in a second state, and
✔ if the authentification signal is in a first state, in a looped state where the configurable cells are operationally connected to interconnection cells to form a register containing a counter-reaction,
✔ if the authentification signal is in a second state, in a chained state where the configurable cells are operationally connected in chains to form a shift register.
the process being **characterised in that** it comprises the following steps, consisting in, when the chaining control signal (SCAN_ENABLE) is in the second state and the authentification signal is in the first state:
• entering an identifier into the configurable cells operationally forming the register containing a counter-reaction,
• checking a content of a part of the said configurable cells and
• placing and maintaining the authentification signal in the second state if, after a predefined time, the said content is equal to the expected value.

7. Process according to the previous claim, also comprising an initialisation step for the content of the configurable cells.

## Patentansprüche

1. Elektronischer Schaltkreis, eine Vielzahl konfigurierbarer Zellen (2a, ..., 2z) umfassend, die geeignet sind, mit logischen Zellen (10 bis 15) funktionell verbunden zu werden, mit denen sie zusammenwirken, um mindestens eine logische Schaltung zu bilden, wenn sich ein Verkettungssteuersignal (SCAN_ENABLE) in einem ersten Zustand befindet,
wobei der elektronische Schaltkreis ebenfalls einen Zusammenschaltungskreis (200) umfasst, der mehrere Zusammenschaltungszellen (210a, 210b, 210c) umfasst, die jeweils umfassen:
• einen ersten Dateneingang, der mit einem Datenausgang einer ersten konfigurierbaren Zelle verbunden ist,
• einen Datenausgang, der mit einem Testeingang einer zweiten konfigurierbaren Zelle höheren Ranges, als dem der ersten konfigurierbaren Zelle, verbunden ist, und
ein Kombinations- und Verbindungsmittel, das in der Lage ist, den ersten Dateneingang der Zusammenschaltungszelle mit dem Ausgang der Zusammenschaltungszelle zu verbinden, wenn sich ein Authentifizierungssignal (COM) in einem zweiten Zustand befindet und sich das Verkettungssteuersignal in einem zweiten Zustand befindet, **dadurch gekennzeichnet, dass** jede Zusammenschaltungszelle (210a, 210b, 210c) einen zweiten Dateneingang umfasst, der an den Datenausgang der zweiten konfigurierbaren Zelle oder an den Datenausgang einer dritten konfigurierbaren Zelle höheren Ranges, als dem der zweiten konfigurierbaren Zelle, angeschlossen ist, wobei das ein Kombinations- und Verbindungsmittel außerdem in der Lage ist, den ersten Dateneingang der Zusammenschaltungszelle mit dem zweiten Dateneingang der Zusammenschaltungszelle zu kombinieren und das Ergebnis der Kombination an den Ausgang der Zusammenschaltungszelle anzulegen, wenn sich das Authentifizierungssignal (COM) in einem ersten Zustand befindet, sofern sich ein Verkettungssteuersignal im zweiten Zustand befindet,
und dadurch, dass der elektronische Schaltkreis außerdem eine Detektionsschaltung (300) umfasst, die dafür eingerichtet ist, einen Zeitraum T1 nach einem ersten Übergang des Verkettungssteuersignals (SCAN_ENABLE) in einen zweiten Zustand das Authentifizierungssignal (COM) in den zweiten Zustand zu versetzen und in diesem zu halten, wenn der Inhalt eines Satzes von Y1 konfigurierbaren Zellen der genannten Vielzahl konfigurierbarer Zellen (2a, ..., 2z) einem ersten Bezugswert (REF1) entspricht.

2. Schaltkreis nach Patentanspruch 1, in dem das Kombinations- und Verbindungsmittel umfasst:
• ein logisches Schaltelement (211a, 211b, 211c), das zwei Eingänge aufweist, die an den ersten Dateneingang bzw. an den zweiten Dateneingang der Zusammenschaltungszelle angeschlossen sind,
• einen Multiplexer (212a, 212b, 212c), der zwei Eingänge aufweist, die an den ersten Dateneingang der Zusammenschaltungszelle bzw. an einen Ausgang des logischen Schaltelementes angeschlossen sind.

3. Schaltkreis nach Patentanspruch 1, in dem die Detektionsschaltung (300) umfasst:
• einen Vergleicher (310) zum Vergleichen des Inhalts der Y1 konfigurierbaren Zellen mit dem ersten Bezugswert und Versetzen des Authentifizierungssignals in den zweiten Zustand, wenn der Inhalt der Y1 konfigurierbaren Zellen dem ersten Bezugswert entspricht, und
• eine Validierungsschaltung (320) zur Übergabe des Authentifizierungssignals nach dem Zeitraum T1 an den Zusammenschaltungskreis.

4. Elektronischer Schaltkreis nach einem der vorangehenden Patentansprüche, in dem die Vielzahl konfigurierbarer Zellen in mehrere Pakete konfigurierbarer Zellen unterteilt ist und in dem der Zusammenschaltungskreis mehrere Pakete von Zusammenschaltungszellen umfasst, die den mehreren Paketen konfigurierbarer Zellen zugeordnet sind, um mehrere in Reihe geschaltete Schleifenregister zu bilden, um ein Register auszubilden, das eine Gegenreaktion enthält, wenn sich das Authentifizierungssignal im ersten Zustand befindet.

5. Elektronischer Schaltkreis nach dem vorangehenden Patentanspruch, außerdem mehrere Detektionsschaltungen (300a bis 300q) umfassend, die jeweils einem Paket konfigurierbarer Zellen und einem Paket von Zusammenschaltungszellen zugeordnet sind, wobei jede Detektionsschaltung dafür eingerichtet ist, nach einem zugehörigen Zeitraum (Ta bis Tq) nach einem ersten Übergang des Verkettungssteuersignals (SCAN_ENABLE) in den zweiten Zustand das Authentifizierungssignal (COM) in den zweiten Zustand zu versetzen, wenn der Inhalt des zugeordneten Pakets konfigurierbarer Zellen einem zugehörigen Bezugswert (REFa bis REFq) entspricht.

6. Verfahren zum Testen eines elektronischen Schaltkreises, der eine Vielzahl konfigurierbarer Zellen (2a, ..., 2z) umfasst, die in Abhängigkeit von einem Verkettungssteuersignal (SCAN_ENABLE) und einem Authentifizierungssignal (COM) konfiguriert werden:
• in einen Betriebszustand, in dem die konfigurierbaren Zellen mit logischen Zellen (10 bis 15) funktionell verbunden sind, mit denen sie zusammenwirken, um mindestens einen logischen Schaltkreis zu bilden, wenn sich das Verkettungssteuersignal in einem ersten Zustand befindet,
• wenn sich das Verkettungssteuersignal in einem zweiten Zustand befindet und
✔ wenn sich das Authentifizierungssignal in einem ersten Zustand befindet in einen Schleifenzustand, in dem die konfigurierbaren Zellen mit Zusammenschaltungszellen funktionell verbunden sind, um ein Register zu bilden, das eine Gegenreaktion enthält,
✔ wenn sich das Authentifizierungssignal in einem zweiten Zustand befindet in einen verketteten Zustand, in dem die konfigurierbaren Zellen zu einer Kette verbunden sind, um ein Schieberegister zu bilden,
wobei das Verfahren **dadurch gekennzeichnet ist, dass** es die folgenden Schritte enthält, die darin bestehen, in dem Fall, dass sich das Verkettungssteuersignal (SCAN_ENABLE) im zweiten Zustand befindet und sich das Authentifizierungssignal im ersten Zustand befindet:
• in die konfigurierbaren Zellen, die funktionell das Register bilden, das eine Gegenreaktion enthält, eine Kennung einzutragen,
• den Inhalt eines Teils der genannten konfigurierbaren Zellen zu prüfen und
• das Authentifizierungssignal in den zweiten Zustand zu versetzen und darin zu halten, wenn der genannte Inhalt nach Ablauf eines festgelegten Zeitraums einem erwarteten Wert gleich ist.

7. Verfahren nach dem vorangehenden Patentanspruch, außerdem einen Schritt der Initialisierung des Inhalts der konfigurierbaren Zellen umfassend.
